# EUROPEAN PATENT APPLICATION

(11) **EP 4 709 067 A1**
(43) Date of publication of application: **11.03.2026**
(21) Application number: 25198244.3
(22) Date of filing: 26.08.2025
(51) Int. Cl.: H05K 7/14, F16B 1/00, F16B 19/00

(54) **BLIND FASTENER INSTALL ASSEMBLY**

(30) Priority: 03.09.2024 US 202463690108 P; 12.08.2025 US 202519297349
(71) Applicant: Vertiv Corporation, Westerville, OH 43082 (US)
(72) Inventor: Dowell, Danny, Westerville, 43082 (US); Caldwell, Carl Robert, Westerville, 43082 (US)
(74) Representative: Cousens, Nico

(57) **Abstract**

An apparatus for installing data center components is disclosed. The apparatus includes a fastening member having first and second surfaces opposite one another. A guide bore is attached to the first surface and configured to mate with a guide of a first component. The fastening member includes a fastener bore that extends from the first surface to the second surface. A hook-shaped member of the fastening member extends from the first end, away from the first surface and may engage with a portion of a second component to retain the fastening member for fastening the first component to the second component. The fastener bore may receive a fastening component adapted to mate with fastener such that the fastening member retains the first component to the second component. The fastener is secured to the fastening component by a torque applied to a portion of the fastener proximate the first surface.

## Description

### TECHNICAL FIELD

This disclosure is directed to equipment mounting, and more particularly, mechanisms for mounting equipment.

### BACKGROUND

In various settings, equipment used by an organization needs to be mounted into a fixed position. For example, in data centers, servers and related equipment need to be mounted in various locations therein. As equipment density increases with technological advancements, product footprints may correspondingly shrink.

### SUMMARY

An apparatus for installing data center components is disclosed. The apparatus includes a fastening member having first and second surfaces opposite one another. A guide bore is attached to the first surface and configured to mate with a guide of a first component. The fastening member includes a fastener bore that extends from the first surface to the second surface. A first end of the fastening member includes a hook-shaped member extending from the first end, away from the first surface and is configured to engage with a portion of a second component of the data center to retain the fastening member for fastening the first component to the second component. The fastener bore is configured to receive a fastening component adapted to mate with fastener such that the fastening member retains the first component to the second component, wherein the fastener is secured to the fastening component by a torque applied to a portion of the fastener proximate the first surface of the fastening member.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is a perspective view of a fastening member according to the disclosure.
FIG. 2 is a perspective view of first and second components secured by a fastening member according to the disclosure.
FIG. 3 is another perspective view of first and second components secured by a fastening member according to the disclosure.
FIG. 4 is a flow diagram of one embodiment of a method for mounting equipment using a fastener assembly according to the disclosure.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

For settings such as data centers, equipment density has increased, thereby leading to smaller product footprints. This in turn causes issues in installing and servicing equipment, as traditional mechanisms may complicate access thereto. The present disclosure comprises a mechanism that allows for installation and access of components (e.g., bus bars) without tool access to the rear of the components. This allows for increased serviceability with a reduced footprint.

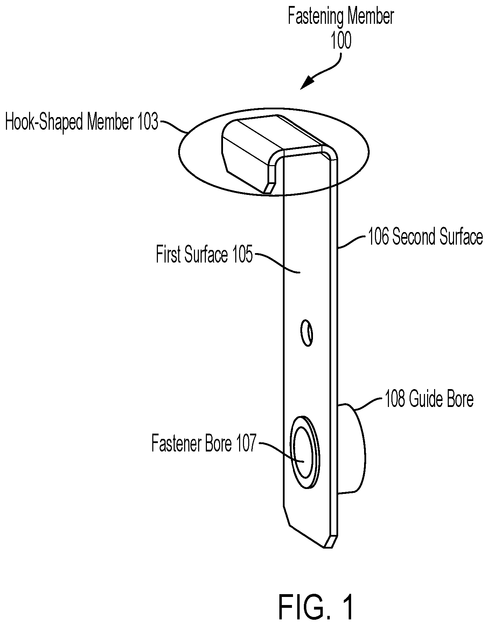

FIG. 1 is a perspective view of a fastening member according to the disclosure. Fastening member 100 includes a first surface 105 and a second surface 106 opposite of the first surface. The fastening member 100 includes, at one end, a hook-shaped member 103 that may secure another component when used to mount equipment.

Fastening member 100 also includes, near the end opposite that of the hook shaped member 103, a fastener bore 107 and a guide bore 108. The fastener bore 107 may be able to receive a fastener, such as a bolt, and may include threads therein to enable the fastener to be secured. The guide bore 108 is arranged to mate with a corresponding guide of another component that is to be secured by fastening member 100. In some embodiments, the guide bore 108 and the remainder of fastening member 100 are made of different materials. The guide bore 108 may be made of a flexible material (e.g., rubber) while the remainder of fastener assembly may be made of a rigid material (e.g., steel).

The arrangement of fastening member 100 may enable the securing of various types of equipment when access is limited. Access to the rear may be limited or unavailable altogether in some equipment mounting configurations. However, with the arrangement of fastening member 100, including guide bore 108 and fastener bore 107, equipment may be secured with access on only one side.

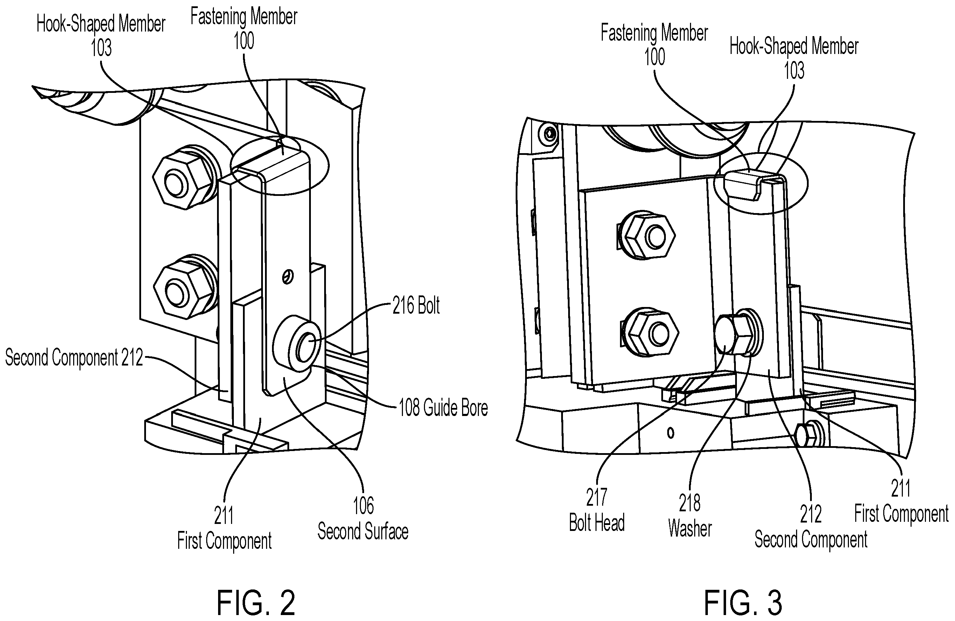

FIGS. 2 and 3 are perspective views of first and second components secured by a fastening member according to the disclosure. In some embodiments, fastening member 100 is used to secure first component 211 and second component 212 to one another, with the latter being additionally secured to other components. The hook shaped member 103 of fastening member 100 partially secures second component 212 into position in this particular example.

A bolt 216 extends from the one side of second component 212, through first component 211, and through fastening member 100. A bolt head 217 of bolt 216 is in contact with a washer 218 that is interposed between the former and the surface of second component 212. Bolt 216 may pass through fastener bore 107 and may be secured by applying torque thereto such that first component 211, second component 212, and washer 218 are held substantially in place.

As previously noted, the arrangement of fastening member 100 may enable access from only one side when access to the other side is limited or altogether unavailable. Fastening member 100 may be used to secure equipment attached to first component 211, using bolt 216, from the side upon which bolt head 217 is accessible and without requiring any access to the other side. This may enable equipment to be installed, secured, and/or removed from tight spaces more easily than would otherwise be possible with fastening members where access to both sides is necessitated.

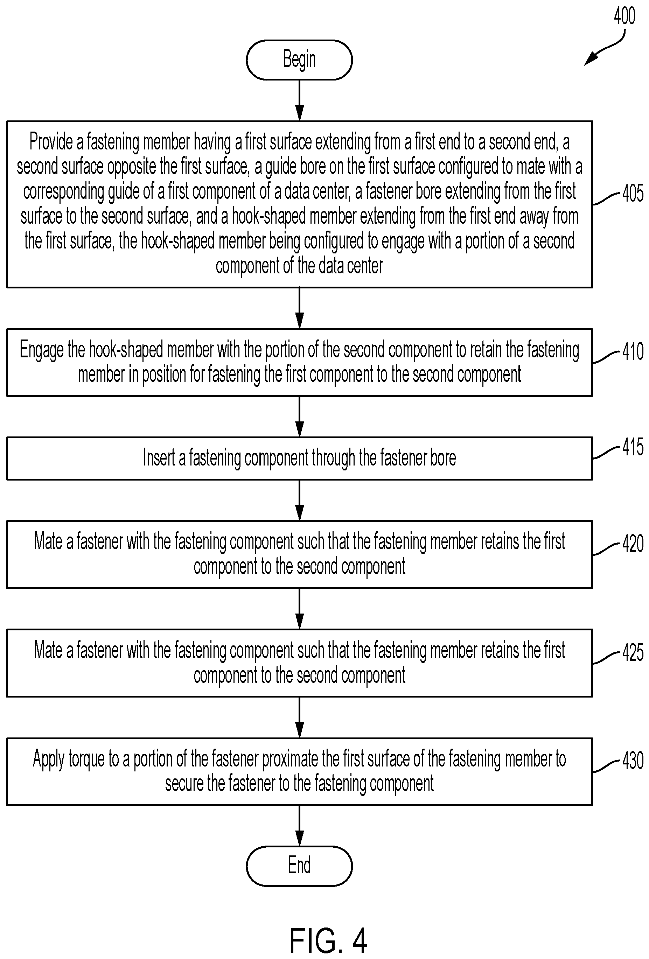

FIG. 4 is a flow diagram of one embodiment of a method for mounting equipment using a fastener assembly according to the disclosure. Method 400 includes providing a fastening member having a first surface extending from a first end to a second end, a second surface opposite the first surface, a guide bore on the first surface configured to mate with a corresponding guide of a first component of a data center, a fastener bore extending from the first surface to the second surface, and a hook-shaped member extending from the first end away from the first surface, the hook-shaped member being configured to engage with a portion of a second component of the data center (block 405). The method further includes engaging the hook-shaped member with the portion of the second component to retain the fastening member in position for fastening the first component to the second component (block 410) and inserting a fastening component through the fastener bore (block 415). The method further includes mating a fastener with the fastening component such that the fastening member retains the first component to the second component (block 420) and applying torque to a portion of the fastener proximate the first surface of the fastening member to secure the fastener to the fastening component (block 425).

In various embodiments, the method includes securing of the first component to the second component by accessing the fastener bore from the first surface when the fastener bore is otherwise inaccessible from the second surface.

Some embodiments of the method include securing, using a bolt of the fastening component, the fastening member to the first component and the second component via a fastener bore. Such embodiments may further include securing a surface of first component to be in contact with a surface of the second component and securing a washer between a head of the bolt and the first surface when the fastening member is secured to the first component and the second component.

Embodiments of the method may include the guide bore extending through a corresponding opening of first component and the second component when secured by the fastening member.

Also disclosed are the following numbered clauses:
1. A fastening apparatus for enabling blind installation of data center components, the apparatus comprising:
   a fastening member having a hook-shaped member extending from a first end, wherein the fastening member includes a first surface extending through an inner portion of the hook-shaped member, and second surface opposite the first surface;
   a fastener bore that extends from the first surface to the second surface; and
   a guide bore configured to mate with a corresponding guide of a first component of a data center;
   wherein the hook-shaped member is configured to engage with a portion of a second component of the data center to retain the fastening member for fastening the first component to the second component; and
   wherein the fastener bore is configured to receive a fastening component adapted to mate with fastener such that the fastening member retains the first component to the second component, wherein the fastener is secured to the fastening component by a torque applied to a portion of the fastener proximate the first surface of the fastening member.
2. The fastening apparatus of clause 1, wherein the fastening component comprises a bolt used to secure, via the fastener bore, the fastening member to the first component and the second component, wherein the bolt is further configured to secure a surface of first component to be in contact with a surface of the second component, and wherein the fastening apparatus further comprises a washer arranged between a head of the bolt and the first surface when the fastening member is secured to the first component and the second component.
3. The fastening apparatus of clause 1 or 2, wherein the first component and the second component are each include a corresponding opening to accommodate the guide bore such that, when secured by the fastening member, the guide bore extends through the corresponding opening of first component and the second component.
4. The fastening apparatus of any preceding clause, wherein the fastening member is comprises of a first material, and wherein the guide bore is comprised of a second material different from the first material, and wherein the first material is a rigid material, and wherein the second material is a flexible material.
5. The fastening apparatus of any preceding clause, wherein the fastener bore is coaxial with the guide bore.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the scope as defined by the following claims.

## Claims

1. An apparatus for installing data center components, the apparatus comprising:
a fastening member having a first surface extending from a first end of the fastening member to a second end of the fastening member and a second surface opposite the first surface, wherein the fastening member includes:
a guide bore configured to mate with a corresponding guide of a first component of a data center; and
a fastener bore that extends from the first surface to the second surface; and
a first end of the fastening member including a hook-shaped member extending from the first end, away from the first surface, the hook-shaped member being configured to engage with a portion of a second component of the data center to retain the fastening member for fastening the first component to the second component; and
wherein the fastener bore is configured to receive a fastening component adapted to mate with fastener such that the fastening member retains the first component to the second component, wherein the fastener is secured to the fastening component by a torque applied to a portion of the fastener proximate the first surface of the fastening member.

2. The apparatus of claim 1, wherein the fastener bore is arranged to allow fully securing of the first component to the second component by accessing the fastener bore from the first surface when the fastener bore is otherwise inaccessible from the second surface.

3. The apparatus of claim 1 or 2, wherein the fastening component comprises a bolt used to secure, via the fastener bore, the fastening member to the first component and the second component.

4. The apparatus of claim 3, wherein, the bolt is further configured to secure a surface of first component to be in contact with a surface of the second component.

5. The apparatus of claim 4, further comprising a washer arranged between a head of the bolt and the first surface when the fastening member is secured to the first component and the second component.

6. The apparatus of any preceding claim, wherein the first component and the second component are each include a corresponding opening to accommodate the guide bore such that, when secured by the fastening member, the guide bore extends through the corresponding opening of first component and the second component.

7. The apparatus of any preceding claim, wherein the fastening member is comprises of a first material, and wherein the guide bore is comprised of a second material different from the first material.

8. The apparatus of claim 7, wherein the first material is a rigid material, and wherein the second material is a flexible material.

9. The apparatus of any preceding claim, wherein the fastener bore is coaxial with the guide bore.

10. A method for installing a data center component, the method comprising:
providing a fastening member having:
a first surface extending from a first end to a second end;
a second surface opposite the first surface;
a guide bore on the first surface configured to mate with a corresponding guide of a first component of a data center;
a fastener bore extending from the first surface to the second surface;
a hook-shaped member extending from the first end away from the first surface, the hook-shaped member being configured to engage with a portion of a second component of the data center;
engaging the hook-shaped member with the portion of the second component to retain the fastening member in position for fastening the first component to the second component;
inserting a fastening component through the fastener bore;
mating a fastener with the fastening component such that the fastening member retains the first component to the second component; and
applying torque to a portion of the fastener proximate the first surface of the fastening member to secure the fastener to the fastening component.

11. The method of claim 10, securing of the first component to the second component by accessing the fastener bore from the first surface when the fastener bore is otherwise inaccessible from the second surface.

12. The method of claim 10 or 11, further comprising securing, using a bolt of the fastening component, the fastening member to the first component and the second component via a fastener bore.

13. The method of claim 12, further comprising securing a surface of first component to be in contact with a surface of the second component.

14. The method of claim 13, further comprising securing a washer between a head of the bolt and the first surface when the fastening member is secured to the first component and the second component.

15. The method of any of claims 10 to 14, further comprising the guide bore, when secured by the fastening member, extending through a corresponding opening of first component and the second component.
